# EUROPEAN PATENT APPLICATION

(11) **EP 3 425 680 A1**
(43) Date of publication of application: **09.01.2019**
(21) Application number: 18182018.4
(22) Date of filing: 05.07.2018
(51) Int. Cl.: H01L 31/048, H02S 40/12

(54) **ROAD SURFACE POWER GENERATION SYSTEM**

(30) Priority: 06.07.2017 CN 201710546849
(71) Applicant: Beijing Apollo Ding Rong Solar Technology Co., Ltd., Beijing 100176 (CN)
(72) Inventor: WANG, Yunfang, Beijing, Beijing 100176 (CN); DAI, Fengyu, Beijing, Beijing 100176 (CN); HUO, Yanyin, Beijing, Beijing 100176 (CN); CAO, Zhifeng, Beijing, Beijing 100176 (CN)
(74) Representative: Branca, Emanuela

(57) **Abstract**

A road surface power generation system is provided, which includes a glass layer (4, 5), a solar cell chip (2), a substrate (1) and a heating device (6). The solar cell chip (2) is arranged between the glass layer (4, 5) and the substrate (1). The heating device (6) is arranged on the glass layer (4, 5) or the substrate (1). In the road surface power generation system, the heating device is arranged on the glass layer or the substrate, for heating the glass layer, such that frost, snow and ice accumulated on the glass layer can be melted, thereby enhancing the light absorption rate of the solar cell chip, and improving the power generation efficiency.

## Description

This application claims the priority to Chinese Patent Application No. 201710546849.2, titled "ROAD SURFACE POWER GENERATION SYSTEM WITH HEATING DEVICE", filed on July 6, 2017 with the State Intellectual Property Office of People's Republic of China.

### FIELD

The present disclosure relates to the technical field of solar power generation, and in particular to a road surface power generation system.

### BACKGROUND

With continuous development of new energy technologies, solar energy provides people with more convenient energy supply. A site such as a certain plane or space is required to serve as the carrier for solar power generation.

At present, a great number of supporting electrical facilities such as facilities for lighting, monitoring, and instructing are used in the transportation field. Therefore, the demand for electricity is greatly increased. In the transportation field, in addition to roofs of the servicing electrical facilities, many potential spaces and positions can be used for distributing solar power generation devices, among which non-motor vehicle lanes account for a great proportion. For example, surfaces of lanes in parks and pedestrian zones may be used for distributing solar cell chips to serve as integrated carriers for supporting functions of the landscape infrastructures and electrical facilities such as facilities for lighting, monitoring and instructing.

However, in high latitude areas, a road surface is generally covered by frost, snow and ice in winter, such that the power generation efficiency of the solar cell chip arranged in the road surface is influenced.

### SUMMARY

A road surface power generation system is provided according to the present disclosure, to solve the problem in the conventional technology, so as to enhance the light absorption rate and the power generation efficiency.

A road surface power generation system is provided according to the present disclosure, which includes a glass layer, a solar cell chip, a substrate and a heating device. The solar cell chip is arranged between the glass layer and the substrate. The heating device is arranged on the glass layer or the substrate.

In an embodiment, the road surface power generation system further includes a temperature sensor and a control unit. The temperature sensor is configured to detect an ambient temperature. The control unit is electrically connected with the heating device and the temperature sensor, and is configured to control the heating device to generate heat according to the ambient temperature detected by the temperature sensor.

In an embodiment, the road surface power generation system further includes a radiation sensor configured to detect light intensity. The radiation sensor is electrically connected with the control unit. The control unit is further configured to control the heating device to generate heat based on the light intensity detected by the radiation sensor.

In an embodiment, the road surface power generation system further includes an electronically controlled switch arranged between the heating device and the control unit.

In an embodiment, in the road surface power generation system, the solar cell chip is arranged on a surface of the substrate facing the glass layer.

In an embodiment, in the road surface power generation system, the glass layer includes an upper glass layer and a lower glass layer. The upper glass layer is fixedly connected to the lower glass layer through a sheet adhesive layer. The solar cell chip is arranged on a side of the lower glass layer close to the substrate.

In an embodiment, in the road surface power generation system, the heating device is a transparent conductive heating film. The heating device is arranged between the upper glass layer and the sheet adhesive layer, arranged between the sheet adhesive layer and the lower glass layer, or arranged on the side of the lower glass layer close to the substrate.

In an embodiment, in the road surface power generation system, the heating device is a thermal resistor, and the heating device is embedded in the substrate or arranged on a side of the substrate away from the solar cell chip.

In an embodiment, in the road surface power generation system, the substrate is an aluminum substrate.

In an embodiment, in the road surface power generation system, an anti-slip layer is arranged on an upper surface of the upper glass layer, and a hardened coating is arranged on the anti-slip layer.

In the road surface power generation system according to the present disclosure, the heating device is arranged on the glass layer or the substrate for heating the glass layer, such that frost, snow and ice accumulated on the glass layer can be melted, thereby enhancing the light absorption rate of the solar cell chip, and improving the power generation efficiency.

### BRIEF DESCRIPTION OF THE DRAWINGS

Figure 1 is a schematic structural diagram of a road surface power generation system with a heating device according to an embodiment of the present disclosure;
Figure 2 is an enlarged view of a part A in Figure 1; and
Figure 3 is a block diagram illustrating a control circuit of a road surface power generation system with a heating device according to an embodiment of the present disclosure.

Reference signs in the drawings are listed as follows:

| | |
|---|---|
| 1-substrate | 2-solar cell chip |
| 3-sheet adhesive layer | 4-upper glass layer |
| 5-lower glass layer | 6-heating device |
| 7-temperature sensor | 8-control unit |
| 9-radiation sensor | 10-electronically controlled switch |

### DETAILED DESCRIPTION OF EMBODIMENTS

The embodiments of the present disclosure are described in detail hereinafter, and are illustrated in drawings, in which the same or similar reference signs represent the same or similar elements or elements with the same or similar functions throughout the description. The embodiments described in the following with reference to the drawings are only exemplary embodiments which are used to explain the present disclosure, and should not be construed to limit the present disclosure.

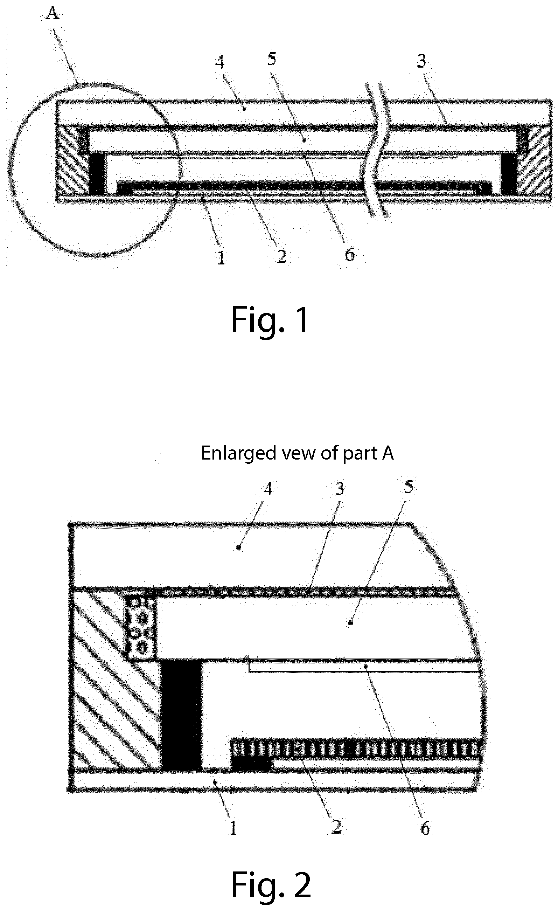

Figure 1 is a schematic structural diagram of a road surface power generation system according to an embodiment of the present disclosure, and Figure 2 is an enlarged view of a part A in Figure 1. A road surface power generation system is provided according to an embodiment of the present disclosure, which includes a glass layer (which may include an upper glass layer 4 and a lower glass layer 5), a solar cell chip 2, a substrate 1 and a heating device 6.

The substrate 1 is arranged in a road surface as a base for installingthe entire road surface power generation system. The solar cell chip 2 is arranged between the glass layer and the substrate 1. The heating device 6 is arranged on the glass layer or the substrate 1 to heat the glass layer, for melting frost, snow and ice accumulated on the glass layer.

In the road surface power generation system according to the present disclosure, the heating device 6 is arranged on the glass layer or the substrate 1 for heating the glass layer, such that frost, snow and ice accumulated on the glass layer can be melted, thereby enhancing the light absorption rate of the solar cell chip 2, and improving the power generation efficiency.

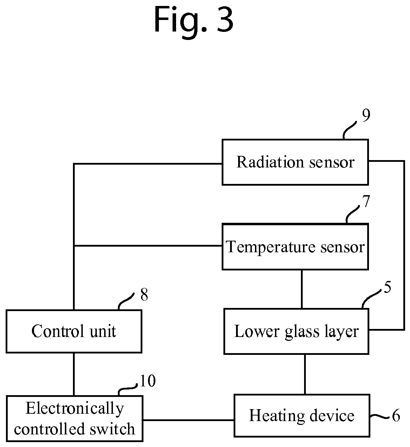

Preferably, the heating device 6 is controlled in the following manner. As shown in Figure 3, which is a block diagram illustrating a control circuit of a road surface power generation system according to an embodiment of the present disclosure, the road surface power generation system further includes a temperature sensor 7 and a control unit 8. The temperature sensor 7 is configured to detect an ambient temperature. The temperature sensor 7 may be directly arranged on the glass layer to directly detect the temperature of the glass layer. Alternatively, the temperature sensor 7 may be secured on another component of the road surface power generation system through a bracket and the like, such that the temperature sensor 7 may indirectly detect the temperature of the glass layer by detecting an air temperature. The control unit 8 is electrically connected with the heating device 6 and the temperature sensor 7, and is configured to control the heating device 6 to generate heat according to the ambient temperature detected by the temperature sensor 7.

Further, the road surface power generation system may include a radiation sensor 9 configured to detect light intensity. Similarly, the radiation sensor 9 may be directly arranged on the glass layer to directly detect the light intensity on the glass layer. Alternatively, the radiation sensor 9 may be secured on another component of the road surface power generation system through a bracket and the like, such that the radiation sensor 9 may indirectly detect the light intensity on the glass layer by detecting the light intensity on another component. The radiation sensor 9 is also electrically connected with the control unit 8. The control unit 8 is further configured to control the heating device 6 to generate heat based on the light intensity detected by the radiation sensor 9.

Further, the road surface power generation system may include an electronically controlled switch 10 arranged between the heating device 6 and the control unit 8. When the electronically controlled switch 10 is turned on, the heating device 6 is controlled to start heating, and when the electronically controlled switch 10 is turned off, the heating device 6 stops operating.

Those skilled in the art may understand that the above solar cell chip 2 may be arranged at many positions. In an embodiment, the solar cell chip 2 is arranged on a surface of the substrate 1 facing the lower glass layer 5.

In order to improve the cushioning effect of the glass layer and avoid fracture of the glass layer, the glass layer may include an upper glass layer 4 and a lower glass layer 5, where the upper glass layer 4 is fixedly connected to the lower glass layer 5 through a sheet adhesive layer 3. In another embodiment, the solar cell chip 2 is arranged on a side of the lower glass layer 5 close to the substrate 1. By providing the double layer glass, the tolerance of the road surface can be improved. The sheet adhesive layer 3 may be made of ethylene-vinyl acetate copolymer (EVA), polyvinyl butyral (PVB), polyolefin elastomer (POE) or 2,4,6-trimethylbenzoyl-diphenyl phosphine oxide (TPO). In order to meet the requirement for strength, each the upper glass layer 4 and the lower glass layer 5 has a thickness ranging from 3mm to 15mm, and preferably has a thickness of 10mm.

The heating device 6 may be implemented in many ways. For example, the heating device 6 may be a transparent conductive heating film. The heating device may be arranged between the upper glass layer 4 and the sheet adhesive layer 3, arranged between the sheet adhesive layer 3 and the lower glass layer 5, or arranged on the side of the lower glass layer 5 close to the substrate 1. Preferably, the transparent conductive heating film is arranged between the upper glass layer 4 and the sheet adhesive layer 3. With this arrangement, not only an optimal temperature transfer effect can be achieved to melt frost, ice and snow, but also the toughness of the glass layer is improved to make the glass layer less likely to crack.

The heating device 6 may also be a thermal resistor and is embedded in the substrate 1 or arranged on a side of the substrate 1 away from the solar cell chip 2. Preferably, the substrate 1 is a metal substrate with a good thermal conductivity. In the present embodiment, the substrate 1 is an aluminum substrate.

Further, an anti-slip layer is arranged on an upper surface of the upper glass layer 4. A hardened coating is arranged on the anti-slip layer to increase the abrasion resistance of the glass layer.

In the description of the present disclosure, it is to be understood that the orientations or positional relationships indicated by the terms "up", "down" and the like are based on the orientations or positional relationships shown in the drawings, which are merely to facilitate the description of the present disclosure and to simplify the description, rather than indicating or implying that the device or element referred to must be in a particular orientation or constructed and operated in a particular orientation, thus these the orientations or positional relationships are not to be construed as limitations to the disclosure.

Structure, characteristics and effects of the present disclosure are described above in detail based on the embodiments illustrated in drawings. The embodiments described above are only preferred embodiments of the present disclosure. The present disclosure is not limited to the scope of implementation as illustrated by the drawings. Any simple changes, equivalents and modifications made to the embodiments based on the technical essence of the present disclosure without departing from the technical solution of the present disclosure fall within the protection scope of the technical solution of the present disclosure.

## Claims

1. A road surface power generation system, comprising:
a glass layer,
a solar cell chip,
a substrate, and
a heating device, wherein
the solar cell chip is arranged between the glass layer and the substrate, and
the heating device is arranged on the glass layer or the substrate.

2. The road surface power generation system according to claim 1, further comprising:
a temperature sensor configured to detect an ambient temperature; and
a control unit electrically connected with the heating device and the temperature sensor, and configured to control the heating device to generate heat according to the ambient temperature detected by the temperature sensor.

3. The road surface power generation system according to claim 2, further comprising a radiation sensor configured to detect light intensity, wherein
the radiation sensor is electrically connected with the control unit, and
the control unit is further configured to control the heating device to generate heat based on the light intensity detected by the radiation sensor.

4. The road surface power generation system according to claim 2 or 3, further comprising an electronically controlled switch arranged between the heating device and the control unit.

5. The road surface power generation system according to claim 4, wherein the solar cell chip is arranged on a surface of the substrate facing the glass layer.

6. The road surface power generation system according to claim 4, wherein the glass layer comprises an upper glass layer and a lower glass layer,
the upper glass layer is fixedly connected to the lower glass layer through a sheet adhesive layer, and
the solar cell chip is arranged on a side of the lower glass layer close to the substrate.

7. The road surface power generation system according to claim 6, wherein the heating device is a transparent conductive heating film, and
the heating device is arranged between the upper glass layer and the sheet adhesive layer, arranged between the sheet adhesive layer and the lower glass layer, or arranged on the side of the lower glass layer close to the substrate.

8. The road surface power generation system according to claim 6, wherein the heating device is a thermal resistor, and the heating device is embedded in the substrate or arranged on a side of the substrate away from the solar cell chip.

9. The road surface power generation system according to claim 8, wherein the substrate is an aluminum substrate.

10. The road surface power generation system according to claim 6, wherein an anti-slip layer is arranged on an upper surface of the upper glass layer, and a hardened coating is arranged on the anti-slip layer.
